# EUROPÄISCHE PATENTANMELDUNG

(11) **EP 0 936 670 A2**
(43) Veröffentlichungstag der Anmeldung: **18.08.1999**
(21) Anmeldenummer: 98123760.5
(22) Anmeldetag: 14.12.1998
(51) Int. Cl.: H01L 23/62, H01L 23/495

(54) **Leistungshalbleiter-Modul**

(30) Priorität: 12.02.1998 DE 19805785
(71) Anmelder: SIEMENS AKTIENGESELLSCHAFT, 80333 München (DE)
(72) Erfinder: Tröger, Wolfgang, 81543 München (DE); Graf, Alfons, Dr., 86916 Kaufering (DE)

(57) **Zusammenfassung**

Die Erfindung betrifft ein Verfahren zum Abschalten des Laststromes eines Leistungshalbleiter-Bauelementes und ein Leistungshalbleiter-Modul zur Durchführung des Verfahrens, mit mindestens einem auf einem Leadframe befestigten und zumindest teilweise von einem Gehäuse umhüllten Leistungshalbleiter-Bauelement, das elektrisch leitend verbunden ist mit einer Mehrzahl von Ausgangsleitung. Für den Fall, daß die Betriebstemperatur des Leistungshalbleiter-Bauelementes (3) eine vorgegebene Temperaturschwelle überschreitet, wird der Laststrom des Leistungshalbleiter-Bauelements (3) irreversibel unterbrochen. Hierfür sind Unterbrechungsmittel vorgesehen, die vorzugsweise vom Gehäuse fest umschlossen sind bzw. Bestandteil des Gehäuses selbst sind. Das Material der Unterbrechungsmittel weist dabei bei zunehmender Temperatur eine volumenerweiternde und/oder eine oxidierende und/oder eine explodierende Charakteristik auf. Als Unterbrechungsmaterialen werden ein annähernd ideales Gas, stark oxidierende oder aufschäumende Materialien, Sprengstoff, etc vorgeschlagen.

## Beschreibung

Die Erfindung betrifft ein Leistungshalbleiter-Modul mit mindestens einem auf einem Leadframe befestigten und zumindest teilweise von einem Gehäuse umhüllten Leistungshalbleiter-Bauelement, das elektrisch leitend verbunden ist mit einer Mehrzahl von Ausgangsleitungen und wobei das Leistungshalbleiter-Modul Unterbrechungsmittel aufweist, die für den Fall, daß die Temperatur des Leistungshalbleiter-Bauelementes (3) eine vorgegebene Temperaturschwelle überschreitet, zumindest die laststromführenden Ausgangsleitungen (4a) und/oder die elektrisch leitenden Verbindungen (5) zwischen dem Leistungshalbleiter-Bauelement (3) und zumindest den laststromführenden Ausgangsleitungen (4a) irreversibel unterbrechen.

Beim Einsatz von Halbleiterbauelementen wie zum Beispiel Leistungsschaltern ist ein Fehler bzw. ein Ausfall, wie prinzipiell bei allen elektrischen Geräten, nie vollständig auszuschliessen. Ein möglicher Fehlerfall ist beispielsweise das sogenannte Durchlegieren oder Durchschmelzen, wodurch beispielsweise bei einem Highside-Schalter eine niederohmige Verbindung zwischen der Versorgungsspannungsquelle und dem Ausgangsanschluss bzw. bei einem Lowside-Schalter eine niederohmige Verbindung des Ausgangsanschlusses zur Gerätemasse entsteht. Der elektrische Strom durch den angeschlossenen Laststromkreis des jeweiligen Leistungsschalters kann durch die Ansteuerlogik nicht mehr beeinflusst werden. Somit wird der Laststrom nur durch den Widerstand der Last im Laststromkreis begrenzt.

Für den Fall, dass die Last ebenfalls einen Fehler aufweist, der zum Kurzschluss der Last führt, wird der Laststrom nur noch durch die Leistungsfähigkeit der Spannungsversorgung und somit durch deren Innenwiderstand begrenzt. Am Ausgang des Leistungsschalters fliesst somit permanent ein Laststrom, der dem Maximalstrom der Spannungsversorgung entspricht. Dieser maximale Laststrom verursacht typischerweise eine unkontrollierte Erwärmung des Leistungsschalters, was im ungünstigsten Fall einen Brand verursachen kann.

Typischerweise wird als Vorsorge hierfür eine Schmelzsicherung, beispielsweise ein dünner Widerstandsdraht, verwendet. Diese Schmelzsicherungen werden in den Laststromkreis zwischen der Versorgungsspannungsquelle und dem Halbleiterschalter geschaltet. Im Fall eines zu grossen Stromes unterbricht die Schmelzsicherung den Laststromkreis. Zusätzlich wird typischerweise ein Temperatursensor verwendet werden, der bei einer zu starken Überhitzung des Leistungsschalters, beispielsweise verursacht durch einen zu grossen Laststrom bzw. Kurzschlussstrom, den Leistungsschalter ausschaltet. Diese Vorsorge funktioniert jedoch nur solange das Bauteil nicht defekt ist.

In der US 5,068,706 ist ein Dreiphasen-Gleichrichter beschrieben, der eine Sicherung aufweist, die definiert schmilzt, wenn die Halbleiterbauelemente eine vorgegebene Temperatur überschreiten. Eine Zerstörung des Bauelementes ist hierdurch verhindert.

Das Risiko, daß der Leistungsschalter einen niederohmigen Fehler bzw. Kurzschluß aufweist und gleichzeitig die zu schaltende Last ebenfalls einen Kurzschluß aufweist, wird jedoch als unwahrscheinlicher Doppelfehler bewußt in Kauf genommen. Falls dieser Doppelfehler dennoch eintritt, ist der mögliche Schaden verursacht durch einen Brand unverhältnismäßig hoch und nicht abzuschätzen.

Der Erfindung liegt daher die Aufgabe zugrunde, ein Leistungshalbleiter-Modul anzugeben, bei dem im Falle einer unzulässig hohen Erwärmung der Laststromkreis des Leistungshalbleiter-Bauelementes verläßlich unterbrochen wird.

Diese Aufgabe wird erfindungsgemäß durch die in Patentanspruch 1 beanspruchten Merkmale gelöst.

Demnach ist vorgesehen, daß für den Fall, daß die Betriebstemperatur des Leistungshalbleiter-Bauelementes eine vorgegebene Temperaturschwelle überschreitet, der Laststrom des Leistungshalbleite-Bauelementes irreversibel unterbrochen wird.

Das Leistungshalbleiter-Modul beinhaltet deshalb Unterbrechungsmittel (8), die für den Fall, daß die Betriebstemperatur des Leistungshalbleiter-Bauelementes eine vorgegebene Temperaturschwelle überschreitet, zumindest die laststromführenden Ausgangsleitungen und/oder die elektrisch leitenden Verbindungen zwischen dem Leistungshalbleiter-Bauelement und zumindest den laststromführenden Ausgangsleitungen irreversibel unterbrechen, wobei das Material der Unterbrechungsmittel bei zunehmender Temperatur eine volumenerweiternde und/oder eine oxidierende und/oder eine explodierende Charakteristik aufweist.

Durch die Anordnung wird bei einem LeistungshalbleiterBauelement, das sich aufgrund eines unzulässig hohen Laststromes auf Temperaturen erwärmt, die oberhalb eines vorgegebenen, spezifizierten Temperaturbereiches liegen, der Laststromkreis definiert und irreversibel unterbrochen. Durch diese irreversible Unterbrechung wird das ohnehin unbrauchbare Leistungshalbleiter-Bauelement zerstört. Gleichzeitig wird ein sehr viel höherer Schaden, der beispielsweise durch einen Gerätebrand verursacht wird, vermieden.

Hierbei sind Materialien im Gehäuse des Leistungshalbleiter-Moduls vorgesehen bzw. vom Gehäuse fest umpreßt, die bei Überschreiten einer vorher bestimmten kritischen Temperatur den Laststromkreis im Leistungshalbleiter-Schalter in der Weise unterbrechen, in dem das Gehäuse und/oder die laststromführenden Bonddrähte bzw. Ausgangsleitungen irreversibel zerstört werden.

Vorteilhafte Ausgestaltungen und Weiterbildungen sind Kennzeichen der weiteren Unteransprüche.

Die Erfindung wird nachfolgend anhand der in den Figuren der Zeichnung angegebenen Ausführungsbeispiele näher erläutert. Es zeigt dabei:
- Figur 1: den schematischen Aufbau eines erfindungsgemässen Leistungshalbleiter-Moduls zur Durchführung des erfindungsgemässen Verfahrens mit unterschiedlich im Gehäuse des Leistungshalbleiter-Moduls angeordneten Unterbrechungsmitteln (Teilfiguren (a) bis (e));
- Figur 2: die diodenähnlich, angestrebte Temperatur-Volumen-Kennliniencharakteristik der verwendeten Unterbrechungsmittel.

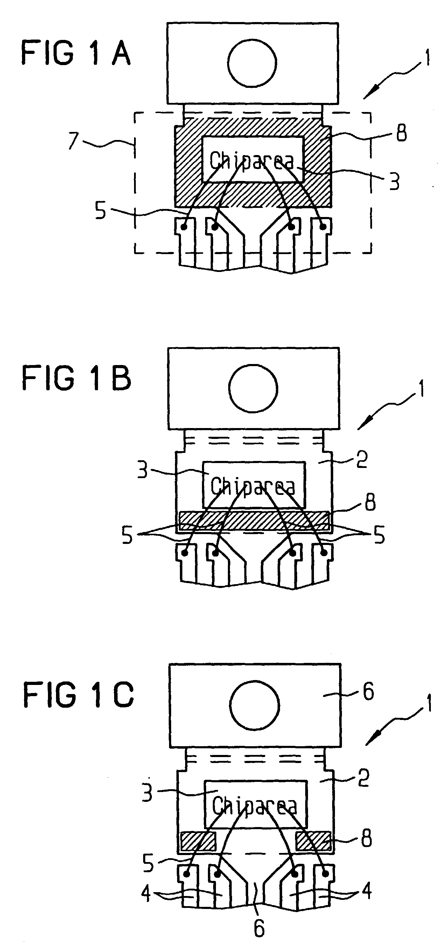

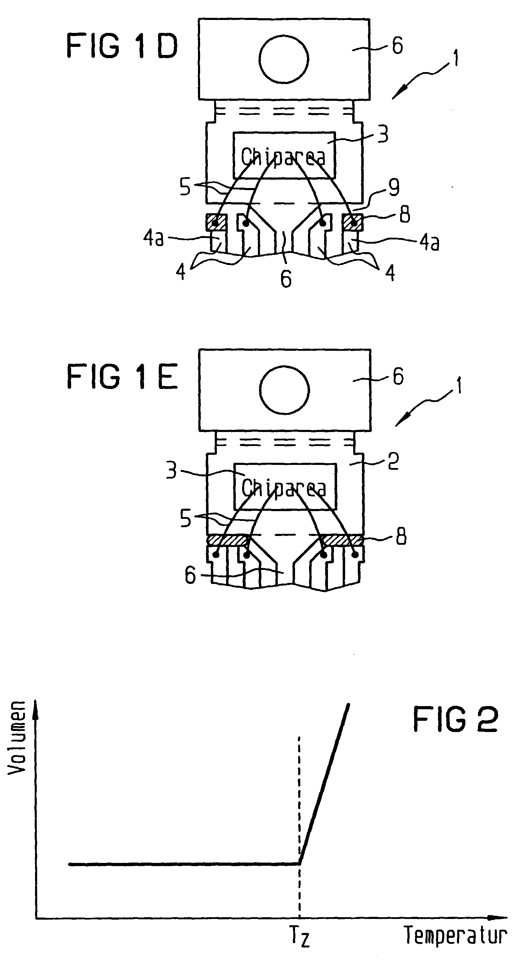

Figur 1 zeigt in verschiedenen Ausführungsbeispiele (a) bis (e) des Aufbaus eines erfindungsgemässen Leistungshalbleiter-Moduls zur Durchführung des erfindungsgemäßen Verfahrens. Dabei sind in den verschiedenene Ausführungsbeispielen gleiche bzw. funktionsgleiche Teile mit gleichen Bezugszeichen versehen.

Das Leistungshalbleiter-Modul ist hier mit 1 bezeichnet. Das Leistungshalbleiter-Modul 1 besteht aus einem Leadframe 2. Auf dem Leadframe 2 ist ein einzelnes Leistungshalbleiter-Bauelement 3 montiert. Es wäre jedoch auch denkbar, eine Mehrzahl von Leistungshalbleiter-Bauelementen 3 auf dem Leadframe 2 anzuordnen. Bei den verwendeten LeistungshalbleiterBauelementen 3 handelt es sich um jede Art von Leistungsschaltern, wie beispielsweise Highside-Schaltern, Lowside-Schaltern, Brückenschaltern, etc. Das erfindungsgemässe Verfahren bzw. die erfindungsgemässe Anordnung ist jedoch auch bei sämtliche andere Bauelemente anwendbar, bei denen eine unkontrolliert hohe Erwärmung möglichst vermieden werden soll.

Im vorliegenden Ausführungsbeispiel ist das Halbleiterbauelement 3 beispielsweise über eine weichlötende Verbindung mit dem Leadframe 2 verbunden. Diese weichlötende Verbindung weist typischerweise eine gute elektrische sowie thermische Leitfähigkeit auf. In diesem Fall sind die Anschlüsse 6, die ebenfalls elektrisch leitend mit dem Leadframe 2 verbunden sind, die Anschlussleitungen für das Potential der Gerätemasse.

Das Leistungshalbleiter-Modul 1 weist ausserdem eine Vielzahl von Ausgangsleitungen 4 auf, die im vorliegenden Ausführungsbeispiel über Verbindungsleitungen 5 mit den entsprechenden Kontaktstellen des Leistungshalbleiter-Bauelementes 3 elektrisch leitend verbunden sind. Vorzugsweise werden als Verbindungsleitungen 5 Bonddrähte verwendet, es sind aber Metallbrücken oder ähnliches als leitende Verbindung denkbar. Die Anschlußleitungen können dabei aus einem weiteren, beispielsweise aus Blech bestehenden Leitungssystem bestehen.

Die laststromführenden Ausgangsleitungen sind in Figur 1 mit 4a bezeichnet. Im vorliegenden Ausführungsbeispiel sind die Ausgangsleitungen 4 vom Leadframe 2 und somit vom Leistungshalbleiter-Bauelement 3 durch einen Zwischenraum 9 beabstandet.

Zur definierten Fixierung der Ausgangsleitungen 4 relativ zum Leadframe 2 sowie zum Schutz des Leistungshalbleiter-Bauelementes 3 sowie dessen Bonddrähten 5 vor äusseren Einflüssen wie beispielsweise Feuchtigkeit, Korrosion, mechanischer Beanspruchung, etc. ist das Leistungshalbleiter-Modul in der Weise von einem Gehäuse 7 umhüllt (in Figur 1(a) gestrichelt dargestellt), dass lediglich die Ausgangsleitungen 4 und Masseleitungen 6 aus dem Gehäuse 7 herausragen. In diesem Fall sind die Anschlußleitungen 4, 6 auch die Gehäuseanschlüsse. Das Gehäuse 7 besteht typischerweise aus Kunststoffmaterial, kann jedoch auch aus anderen Materialien bestehen. Bei der Herstellung wird dabei typischerweise das Kunststoffmaterial in die gewünschte Form gepresst.

Im vorliegenden Beispiel in Figur 1 ist ein sogenanntes TO-Gehäusebauteil gezeigt. Die Erfindung betrifft jedoch alle denkbaren Gehäusebauteile.

Mit 8 sind die Unterbrechungsmittel bezeichnet. In den Ausführungsbeispielen in Figur 1 sind die Unterbrechungsmittel 8 fest umpresst oder Bestandteil des Gehäuses 7 selbst. Dies ist jedoch nicht notwenigerweise erforderlich. Es wäre auch denkbar, dass die Unterbrechungsmittel zumindest teilweise außerhalb des Gehäuses 7 angeordnet sind, beispielsweise um die laststromführenden Ausgangsleitungen 4a herum, der Gehäuseoberfläche, etc.

Nachfolgend wird das angewandte Verfahren näher erläutert:

Das Material der Unterbrechungsmittel 8, nachfolgend auch als Unterbrechungsmaterial bezeichnet, ist typischerweise vom Gehäuse 7 fest umpresst oder Bestandteil des Gehäuses 7 selbst. Bei Überschreiten einer vorbestimmten kritischen Temperatur wird typischerweise das Gehäuse 7 durch das Unterbrechungsmaterial in der Weise zerstört, dass auch zumindest die lastführenden Bonddrähte 5 bzw. zumindest die lastführenden Ausgangsleitungen 4a und/oder das Leistungshalbleiter-Bauelement 3 selbst zerstört bzw. irreversibel unterbrochen wird. Durch diese Unterbrechung wird der Laststromkreis des Leistungshalbleiter-Bauelements 3 ebenfalls unterbrochen.

Als kritische Temperatur T₂ wird nachfolgend diejenige Temperatur bezeichnet, bei der das Halbleiterbauelement definiert und sicher zerstört werden soll. Typischerweise liegt die kritische Temperatur deutlich oberhalb der Temperatur im Normalbetrieb des Halbleiterbauelementes bzw. auch oberhalb der Temperaturen, die im Herstellungsprozeß des Gehäusebauteils entstehen.

Es wäre jedoch auch denkbar, dass das Unterbrechungsmaterial 8 Bestandteil der (stromführenden) Ausgangsleitungen 4, 4a oder den entsprechenden Bonddrähten 5 zum Halbleiterbauelement 3 sind. In diesem Fall werden diese Leitungen durch die Unterbrechungsmittel 8 direkt zerstört.

Dabei werden die nachfolgenden drei bevorzugten Mechanismen zur Unterbrechung vorgeschlagen:
1. Das Unterbrechungsmaterial verändert ab der kritischen Temperatur den Bonddraht 5 bzw. die (lastführenden) Ausgangsleitungen 4, 4a chemisch, indem es beispielsweise oxidiert. Auf diese Weise werden die Bonddrähte 5 bzw. die Ausgangsleitungen 4, 4a hochohmig, wodurch der Laststromkreis unterbrochen wird. In diesem Fall ist es vorteilhaft, wenn das Unterbrechungsmaterial in das Material des Bonddrahtes 5 bzw. der Ausgangsleitungen 4, 4a einlegiert ist. Denkbar wäre auch, wenn das Unterbrechungsmaterial auf die Oberfläche der Ausgangsleitungen 4, 4a bzw. Bonddrähte 5 oder in dessen Leitungskern enthalten ist.
2. Das Unterbrechungsmaterial, beispielsweise aber nicht notwendigerweise ein Gas, verändert sein Volumen mit zunehmender Temperatur in der Weise, dass bei ansteigender Temperatur sich die Unterbrechungsmaterial sehr stark ausdehnt. Da das Unterbrechungsmaterial aber fest vom Gehäuse 7 umschlossen wird bzw. Bestandteil des Gehäuses 7 ist, ist eine Volumenausdehnung des Unterbrechungsmaterials bei zunehmender Temperatur nur begrenzt möglich. Jedoch wird ein zunehmender Druck auf das Gehäuse 7 ausgeübt. Wird die kritische Temperatur überschritten, ist der Druck zu groß für das Gehäuse 7 geworden, so dass es schlagartig zur Zerstörung des Gehäuses 7 kommt. Die Bonddrähte 5, die im Vergleich zu den Ausgangsleitungen 4 verhältnismässig dünn ausgebildet sind, werden durch die Zerstörung des Gehäuses 7 abgerissen bzw. unterbrochen und der Laststrom wird auf diese Weise definiert sicher und irreversibel unterbrochen.
3. Das zusätzliche Material zündet bzw. explodiert ab der kritischen Temperatur und sprengt somit das Gehäuse 7 und damit die Bonddrähte 5 äquivalent wie unter 2. beschrieben.

Als Unterbrechungsmaterial kommen prinzipiell alle Materialien in Frage, die eine diodenähnliche Temperatur-Volumen-Kennlinie entsprechend Figur 2 aufweist. Nachfolgend werden beispielhaft einige konkrete Beispiele, die jedoch hier nicht als abschließende Sammlung aufzufassen sind, aufgeführt:
a) Die einfachste Möglichkeit besteht darin, dass kleine Luftblasen in das Gehäuse 7 eingebracht werden. Das Gehäuse wird dann entsprechend dem 2. Mechanismus zerstört. Denkbar wäre jedoch auch jedes andere Gas, das in kleinen Hohlräumen im Gehäuse 7 eingebracht ist und sich bei zunehmender Temperatur im Verhalten einem idealen Gas annähert.
b) Eine weitere Möglichkeit ist die Verwendung eines Unterbrechungsmaterial, das ab der kritischen Temperatur beginnt, stark auszugasen und auf diese Weise das Gehäuse 7 und somit auch die Bonddrähte 5 entsprechend Mechanismus 2 zerstört.
c) Eine überaus wirkungsvolle Massnahme wäre die Verwendung von Sprengstoff, dessen Zündtemperatur im Bereich der kritischen Temperatur liegt. Üblicherweise liegt die Zündtemperatur bei gängigen Sprengstoffen im Bereich zwischen 350°C und 700 °C. Insbesondere wäre dabei eine Zündpille als Unterbrechungsmaterial, ähnlich wie beim Airbag, denkbar. Denkbar wäre auch Silberbromid, dass bei einer Temperatur von etwa 170°C zündet. Bei der Dosierung der Sprengstoffmenge ist darauf zu achten, dass lediglich das Gehäuse 7 und somit die Bonddrähte 5, nicht aber benachbarte Bauelemente bzw. die Platine selbst, durch die Explosion zerstört werden (Mechanismus 3).
d) Eine weitere Möglichkeit wäre die Verwendung von Kunststoffen als Gehäusematerial, die ab der kritischen Temperatur beginnen sich stark auszudehnen, beispielsweise durch Aufschäumen (Mechanismus 2). Ein Beispiel hierfür wäre Polyamid 6.6. Denkbar wäre auch, dieses Kunststoffmaterlal vom Gehäusematerial zu umschliessen.
e) Schlielich wären auch Unterbrechungsmaterialien denkbar, die ab der kritischen Temperatur stark oxidieren (Mechanismus 1), wie beispielsweise Magnesiumcarbonat (MgCO₃). Bei einer Temperatur von etwa 540°C oxidiert MgCO₃ zu CO₂ + MgO.

Die obige Auflistung der möglichen Materialien als Unterbrechungsmittel 8 sollten lediglich als vorteilhafte Ausführungsbeispiele aufgefaßt werden und ist daher nicht abschliessend. Generell kommen sämtliche Materialien in Frage, die entsprechend Figur 2 eine diodenähnliche Volumen-Temperatur-Kennliniencharakteristik aufweisen.

In Figur 1 sind, wie bereits erwähnt, einige Beispiele für einen möglichen Einbauort der obengenannten Unterbrechungsmaterialien dargestellt.

In Figur 1(a) ist das Unterbrechungsmaterial grossflächig auf dem Leadframe 2 aufgebracht. Das Unterbrechungsmaterial ist dabei um das gesamte Halbleiterbauelement 3 herum angeordnet.

Bei Erreichen der kritischen Temperatur wird das Gehäuse 7 abgesprengt und somit die Bonddrähte 5 unterbrochen.

In den Figuren 1(b) und 1(c) ist das Unterbrechnungsmaterial lediglich an der Kante des Leadframe 2 auf der Seite der Ausgangsleitungen 4 angeordnet. Bei Erreichen der kritischen Temperatur werden dabei die Bonddrähte 5 entweder sofort unterbrochen oder durch Aufsprengen des Gehäuses 7 an dieser Stelle vom Halbleiterbauelement 3 bzw. dessen Ausgangsleitungen 4 abgerissen. Im Unterschied zu Figur 1b ist dabei in Figur 1c aus ökonomischen Gründen das Unterbrechungsmittel 8 lediglich in der Nähe derjenigen Bonddrähte 5 angeordnet, die das Halbleiterbauelement mit den laststromführenden Ausgangsleitungen 4a verbinden.

In Figur 1(d) ist das Unterbrechungsmittel 8 ausschliesslich an der Kontaktstelle der laststromführenden Bonddrähte 5 zu den entsprechenden Ausgangsleitungen 4a angeordnet.

In Figur 1(e) sind die Unterbrechungsmittel im Zwischenraum 9, der das Leadframe 2 und die Ausgangsleitungen 4 voneinander beabstandet, angeordnet.

Weiterhin ist es auch möglich, die Unterbrechungsmittel auf dem Bonddraht 5 selbst bzw. auf den Ausgangsleitungen 4 selbst aufzubringen (in Figur 1 nicht gezeigt)

Besonders vorteilhaft ist es dann, wenn die Unterbrechungsmittel in das Material der Bonddrähte 5 bzw. der Ausgangsleitungen 4 einlegiert ist. Das Einlegieren der Unterbrechungsmittel wird insbesondere bevorzugt, wenn die entsprechenden Leitungen bei Erreichen der kritischen Temperatur entsprechend Mechanismus 1 durch Oxidation unterbrochen werden sollen.

Besonders vorteilhaft ist es jedoch, wenn die Unterbrechungsmittel 8 direkt in die Kunststoffpressmasse des Gehäuses 7 (in Figur 1 ebenfalls nicht dargestellt) eingebracht sind.

Besonders vorteilhaft ist es, wenn das Gehäuse 7 an der Stelle, die zerstört werden soll, in geeigneter Weise eingekerbt ist. Dadurch wird eine Sollbruchstelle erzeugt, deren Vorteile nachfolgend erläuter werden:
- Die Unterbrechung wird erleichtert. Die Menge des eingesetzten Unterbrechungsmaterials kann somit verringert werden.
- Die Richtung, in die das abzusprengende Gehäuseeck möglicherweise wegfliegt, kann festgelegt werden. Die Unterbrechung ist somit weitestgehend reproduzierbar bzw. eine mögliche Gefährdung empfindlicher Teile in der Nähe kann vermieden werden.

Die in Figur 1 gezeigten Ausführungsbeispiele sind keinesfalls vollständig. Die Erfindung ist auf alle denkbaren Halbleiterbauelemente anwendbar, bei denen bei Erreichen einer kritischen Temperatur der Strom in den stromführenden Leitung unterbrochen werden soll.

Durch die gezielte Wahl der verwendeten Unterbrechungsmaterialien und/oder deren Dosierung läßt sich gleichermaßen die kritische Temperatur, bei der das Halbleiterbauelement zerstört werden soll, einstellen.

## Patentansprüche

1. Leistungshalbleiter-Modul mit mindestens einem auf einem Leadframe (2) befestigten und zumindest teilweise von einem Gehäuse (7) umhüllten Leistungshalbleiter-Bauelement (3), das elektrisch leitend verbunden ist mit einer Mehrzahl von Ausgangsleitungen (4), und wobei das Leistungshalbleiter-Modul (1) Unterbrechungsmittel (8) aufweist, die für den Fall, daß die Temperatur des Leistungshalbleiter-Bauelementes (3) eine vorgegebene Temperaturschwelle überschreitet, zumindest die laststromführenden Ausgangsleitungen (4a) und/oder die elektrisch leitenden Verbindungen (5) zwischen dem Leistungshalbleiter-Bauelement (3) und zumindest den laststromführenden Ausgangsleitungen (4a) irreversibel unterbrechen,
**dadurch gekennzeichnet,**
daß das Material der Unterbrechungsmittel (8) bei zunehmender Temperatur eine volumenerweiternde und/oder eine oxidierende und/oder eine explodierende Charakteristik aufweist.

2. Leistungshalbleiter-Modul nach einem der Anspruch 1,
**dadurch gekennzeichnet,**
daß die Unterbrechungsmittel (8) zumindest teilsweise als Bestandteil in der Pressmasse des Gehäuses (7) enthalten sind.

3. Leistungshalbleiter-Modul nach einem der Ansprüche 1 oder 2,
**dadurch gekennzeichnet,**
daß die Unterbrechungsmittel (8) zumindest teilweise Sprengstoff enthalten.

4. Leistungshalbleiter-Modul nach einem der Ansprüche 2 bis 3,
**dadurch gekennzeichnet,**
daß die Unterbrechungsmittel (8) zumindest teilweise Magnesiumcarbonat (MgCO₃) enthalten.

5. Leistungshalbleiter-Modul nach einem der Ansprüche 2 bis 4,
**dadurch gekennzeichnet,**
daß die Unterbrechungsmittel (8) zumindest teilweise Silberbromid enthalten.

6. Leistungshalbleiter-Modul nach einem der Ansprüche 2 bis 5,
**dadurch gekennzeichnet,**
daß die Unterbrechungsmittel (8) im Kunststoffmaterial des Gehäuses (7) enthalten sind, wobei das Kunststoffmaterial bei Erreichen der vorgegebenen Temperaturschwelle eine aufschäumende Charakteristik aufweist.

7. Leistungshalbleiter-Modul nach Anspruch 6,
**dadurch gekennzeichnet,**
daß die Unterbrechungsmittel (8) zumindest teilweise Polyamid 6.6 enthalten.

8. Leistungshalbleiter-Modul nach einem der Ansprüche 2 bis 7,
**dadurch gekennzeichnet,**
daß die Unterbrechungsmittel (8) vom Gehäuse umschlossen werden und zumindest teilweise aus einem annähern idealen Gas bestehen.

9. Leistungshalbleiter-Modul nach einem der Ansprüche 2 bis 8,
**dadurch gekennzeichnet,**
daß die Anschlußleitungen (4, 4a) mit dem Leistungshalbleiter-Bauelement (3) durch Bonddrähte (5) verbunden sind.

10. Leistungshalbleiter-Modul nach einem der Ansprüche 2 bis 9,
**dadurch** g**ekennzeichnet,** daß die Un
terbrechungsmittel (8) in unmittelbarer Nähe zum Leistungshalbleiter-Bauelement (3) angeordnet sind.

11. Leistungshalbleiter-Modul nach einem der Ansprüche 2 bis 10,
**dadurch gekennzeichnet,**
daß die Unterbrechungsmittel (8) zumindest teilweise in einem Zwischenbereich (9) zwischen dem Leistungshalbleiter-Bauelement (3) und den Ausgangsleitungen (4, 4a) angeordnet sind.

12. Leistungshalbleiter-Modul nach einem der Ansprüche 2 bis 11,
**dadurch gekennzeichnet,**
daß die Unterbrechungsmittel (8) in unmittelbarer Nähe der Kontaktstelle der Bonddrähte (5) auf den zumindest laststromführenden Ausgangsleitungen (4a) angeordnet sind.

13. Leistungshalbleiter-Modul nach einem der Ansprüche 2 bis 12,
**dadurch gekennzeichnet,**
daß die Unterbrechungsmittel (8) zumindest teilweise im Material der Bonddrähte (5) und/oder im Material der Ausgangsleitungen (4) einlegiert sind.
